**Europäisches Patentamt**

**European Patent Office**

**Office européen des brevets**

(19)

(11) Veröffentlichungsnummer: **0 123 167**
**B1**

# (12) EUROPÄISCHE PATENTSCHRIFT

(45) Veröffentlichungstag der Patentschrift:
03.06.87

(21) Anmeldenummer: **84103461.4**

(22) Anmeldetag: **29.03.84**

(51) Int. Cl.⁴: **H 05 K 13/02, A 47 B 88/16**

(54) **Magazin für plattenförmige Werkstücke, insbesondere Keramikträger für elektronische Bauelemente.**

(30) Priorität: 30.03.83 DE 8309428 U

(43) Veröffentlichungstag der Anmeldung:
31.10.84 Patentblatt 84/44

(45) Bekanntmachung des Hinweises auf die Patenterteilung:
03.06.87 Patentblatt 87/23

(84) Benannte Vertragsstaaten:
AT BE CH DE FR GB IT LI NL SE

(56) Entgegenhaltungen:
DE - A - 1 554 279
DE - A - 2 603 753
DE - A - 2 645 232
DE - A - 2 757 811
DE - B - 2 313 486
US - A - 3 716 282

(73) Patentinhaber: **Schiller, Sieghard, Pfullinger Strasse 58, D-7419 Sonnenbühl 3-Genkingen (DE)**

(72) Erfinder: **Schiller, Sieghard, Pfullinger Strasse 58, D-7419 Sonnenbühl 3-Genkingen (DE)**

(74) Vertreter: **Möbus, Rudolf, Dipl.-Ing., Hindenburgstrasse 65, D-7410 Reutlingen (DE)**

## Beschreibung

Die Erfindung betrifft ein Magazin für plattenförmige Werkstücke, insbesondere Keramikträger für elektronische Bauelemente, mit zwei mit Abstand parallel zueinander verlaufenden Gehäusewänden mit Führungsnuten für Seitenränder der Werkstücke, in welchen Führungsnuten jeweils mehrere Werkstücke, durch Abstandshalter voneinander getrennt, hintereinander angeordnet sind.

Magazine der vorstehend genannten Art werden bekannterweise als Zwischenspeicher in automatischen oder halbautomatischen Fertigungseinrichtungen für elektronische Schaltungen eingesetzt. Sie stehen hierbei in Verbindung mit Transport- und Zuführsystemen, die zum Be- und Entladen der in den Magazinen in mehreren durchgehenden Führungsnuten übereinandergestapelten und in den einzelnen Führungsnuten zu mehreren hintereinander angeordneten Werkstücke Schieber oder Greifer aufweisen. Mittels der Schieber werden die Werkstücke entlang den Führungsnuten verschoben. Um hierbei definierte Lagerstellen im Magazin und gleichzeitig einen gegenseitigen Abstand der hintereinander angeordneten plattenförmigen Werkstücke zu erhalten, ist es bekannt, in die Gehäusewandungen Federelemente einzusetzen, die in die Führungsnuten an den Übergangsstellen zwischen zwei Lagerpositionen ragen und an denen die Werkstücke unter Zurseitedrücken der Federelemente vorbeigeschoben werden können. Diese federnden Abstandshalter haben den Nachteil, dass sie durch das Vorbeischieben der Werkstücke einem starken Verschleiss unterliegen, einen relativ grossen Kraftansatz an den Werkstücken zur Überwindung der Reibung zwischen Abstandshalter und Werkstück erforderlich machen und ausserdem die Herstellung solcher Magazine nicht unwesentlich verteuern.

Der Erfindung liegt die Aufgabe zugrunde, die vorstehend genannten Nachteile zu vermeiden und ein Magazin der eingangs genannten Art zu schaffen, bei welchem weder das Magazin noch die plattenförmigen Werkstücke einer merklichen Verschleissgefahr und Verstellkrafteinwirkung ausgesetzt sind.

Ausgehend von einem Magazin der eingangs genannten Art wird diese Aufgabe erfindungsgemäss dadurch gelöst, dass die Abstandshalter durch Vorsprünge in der Auflagefläche der Führungsnuten gebildet sind und dass die Breite der Führungsnuten und die Höhe der Vorsprünge an die Dicke der plattenförmigen Werkstücke so angepasst sind, dass die Werkstücke in den Führungsnuten durch Anheben über die Vorsprünge hinweg verschiebbar sind. Hierbei können die Vorsprünge zweckmässig entweder durch Verformen der zwischen parallelen Führungsnuten der Gehäusewände befindlichen Stege oder aber durch gesonderte Teile, die in Ausnehmungen dieser Stege jeweils nach oben über den Stegrand überstehend eingesetzt sind, gebildet sein.

Bei einem erfindungsgemäss ausgebildeten Magazin entfallen dem Verschleiss unterworfene und schwierig zu montierende Federelemente. Die als Abstandshalter wirkenden Vorsprünge lassen sich preisgünstig in die Gehäusewandungen einformen oder auf den Gehäusewandungen durch Kleben, Löten oder Schweissen befestigen. In Verbindung mit bekannten sogenannten Hubbalkengreifern lassen sich die im Magazin gespeicherten Werkstücke ohne grossen Kraftaufwand anheben und über die Vorsprünge hinweg von Speicherposition zu Speicherposition verschieben. Erfindungsgemäss ausgebildete Magazine können aber auch in Verbindung mit Verstellschiebervorrichtungen eingesetzt werden. Hierzu sind die Vorsprünge vorteilhafterweise in Längsrichtung der Führungsnut beidseitig mit schrägen oder gerundeten Aufgleitflächen versehen, so dass sich die plattenförmigen Werkstücke durch seitlichen Druck über die die einzelnen Speicherpositionen begrenzenden Abstandshalter hinwegschieben lassen. Die schrägen oder gerundeten Aufgleitflächen bewirken ausserdem eine Selbstzentrierung der Werkstücke auf die einzelnen Speicherpositionen, da sie ein Abrutschen von ungenau abgesetzten Werkstücken in die Speicherposition erlauben.

Zweckmässig ist an beiden Enden der über die ganze Länge einer Gehäusewandung durchlaufenden Führungsnuten ein Vorsprung gemäss der Erfindung und ausserdem eine keilförmige oder trichterförmige Erweiterung der Nut zur Erleichterung des Einschiebens der plattenförmigen Werkstücke in das Magazin vorgesehen. In der Regel sind die Gehäusewände mit den die Führungsnuten begrenzenden Stegen und den Vorsprüngen einstückig aus Metall gebildet, also aus einem widerstandsfähigen Werkstoff, so dass selbst in Einrichtungen, bei denen die Werkstücke nicht durch Hubbalken über die Abstandshalter hinweggehoben, sondern durch Schieber über die Abstandshalter hinweggeschoben werden, die Abstandshalter nicht als die Lebensdauer der Magazine ungebührlich begrenzende Verschleisselemente angesehen werden müssen.

Nachfolgend wird die Erfindung anhand von in der Zeichnung dargestellten Ausführungsbeispielen näher erläutert.

Im einzelnen zeigen:

Fig. 1 eine perspektivische Darstellung eines erfindungsgemäss ausgebildeten Magazins;

Fig. 2 eine Teildraufsicht auf eine der mit den Führungsnuten versehenen Gehäusewände des Magazins;

Fig. 3a–3h acht verschiedene Ausführungsformen der als Abstandshalter in den Führungsnuten wirkenden Vorsprünge.

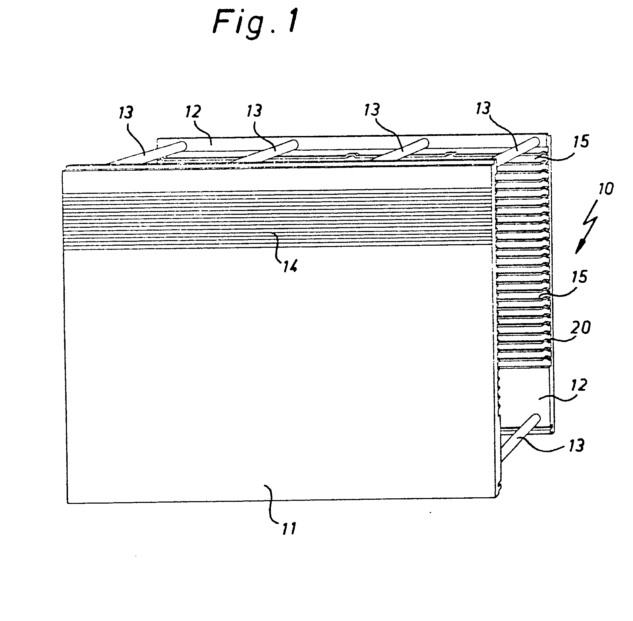

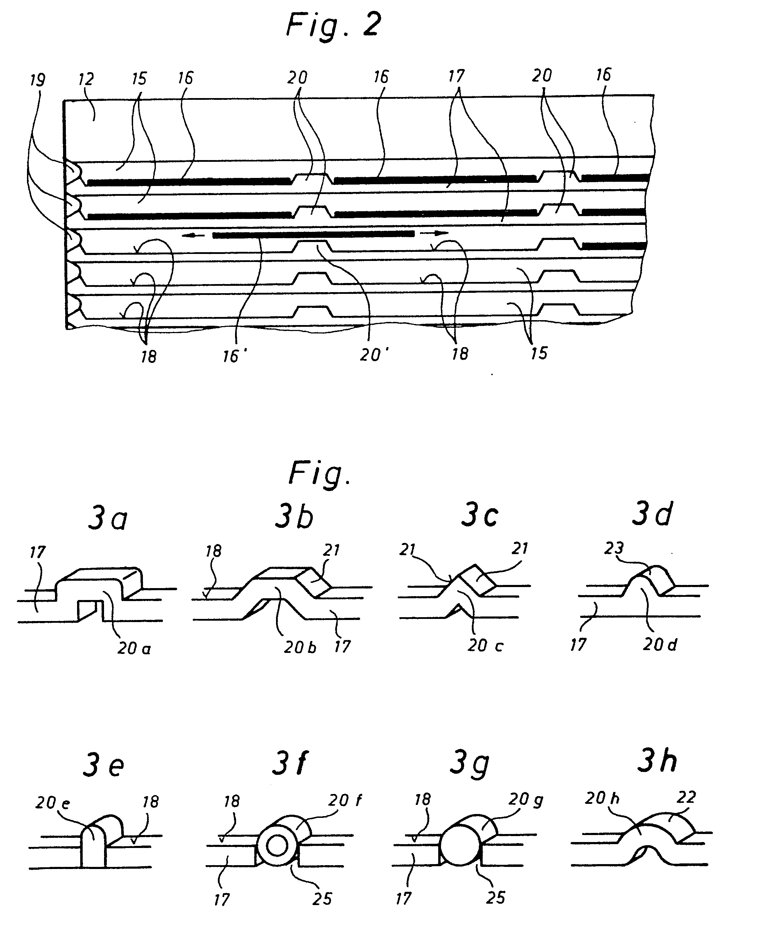

Fig. 1 zeigt ein Magazin 10 zur Aufnahme von Keramikträgern für elektronische Bauelemente, in denen eine Vielzahl solcher plattenförmiger Werkstücke in Reihen und Spalten jeweils mit gegenseitigem Abstand voneinander geordnet gespeichert sind und mittels einer nicht dargestellten, aber an sich in Verbindung mit solchen Magazinen bekannten Hubbalkeneinrichtungen bei freien Speicherpositionen innerhalb der einzelnen Führungsnuten des Magazins versetzt oder dem Magazin entnommen werden können. Das Magazin besteht aus zwei metallischen rechteckigen Gehäusewänden 11 und 12, die entlang ihres oberen Randes und ihres unteren Randes durch mehrere Distanzbolzen 13 in Parallellage und in gleichmässigem Abstand zueinander gehalten sind. Auf ihrer Aussenseite weisen beide Gehäusewände 11 und 12 einen geriffelten Griffbereich 14 auf. Beide Gehäusewände 11 und 12 sind identisch ausgebildet und auf ihrer Innenseite in gleichmässigem Abstand mit von einem Seitenrand zum anderen durchgehenden Führungsnuten 15 versehen, in welche die Seitenränder der in Fig. 2 eingezeichneten plattenförmigen Werkstücke 16 eingreifen. Die einzelnen Nuten 15 sind durch Stege 17 voneinander getrennt, die mit ihrer Oberseite die Auflagefläche 18 der Führungsnuten 15 für die Werkstücke 16 bilden, wie aus Fig. 2 ersichtlich ist.

Die einzelnen Speicherpositionen der Werkstücke 16 in den Führungsnuten 15 sind durch Abstandshalter in Form von über die Auflagefläche 18 vorstehenden Vorsprüngen 20 begrenzt. Die Höhe dieser Vorsprünge 20 und die Breite der Führungsnuten 15 und die Dicke der plattenförmigen Werkstücke 16 sind aneinander so angepasst, dass die Werkstücke 16 in den Führungsnuten 15 nach Abheben von der Auflagefläche 18 über die Vorsprünge 20 hinweg verschiebbar sind. In Fig. 2 ist ein plattenförmiges Werkstück 16' dargestellt, wie es in der einen oder anderen Richtung zwischen zwei Lagerpositionen über den die beiden Lagerpositionen voneinander trennenden Vorsprung 20' hinweggeschoben wird. Fig. 2 zeigt auch, wie die Führungsnuten 15 am Seitenrand der Gehäusewand 12 eine trichterförmige Erweiterung 19 aufweisen, um das Einführen der Werkstücke 16 in die Führungsnuten 15 zu erleichtern.

Die Vorsprünge 20 können auf unterschiedliche Weise gebildet sein und unterschiedliche Formen aufweisen. In den Fig. 3a–3h sind acht verschiedene Ausführungsbeispiele von Vorsprüngen 20a–20h dargestellt. Die in den Fig. 3a, 3b, 3c und 3h dargestellten Vorsprünge 20a, 20b, 20c und 20h sind jeweils durch Ausprägungen der zwischen den Führungsnuten befindlichen Stege 17 geschaffen. Solche Ausprägungen lassen sich sowohl bei vorgefertigten Einzelstegen, die nachträglich auf die glatte Innenwandung der Gehäusewände 11 und 12 aufgesetzt, beispielsweise aufgeklebt werden, als auch bei einstückig mit den Gehäusewänden 11, 12 durch Strangpressen der Seitenwände oder durch Einfräsen der Führungsnuten 15 in die Seitenwände gebildeten Stegen 17 anbringen. Die in Fig. 3b und 3c abgebildeten Vorsprünge 20b sind beidseitig mit schrägen Aufgleitflächen 21 versehen, während die Oberfläche 22 des in Fig. 3h dargestellten Vorsprunges 20h kreisbogenförmig gewölbt ist. Fig. 3d zeigt einen Vorsprung 20d, der an den Steg 17 angeformt ist und ebenfalls eine gerundete Oberfläche 23 aufweist. Ein solcher Vorsprung kann beispielsweise bei aus Metall oder Kunststoff gegossenen Gehäusewandungen 11 und 12 vorgesehen sein.

Die Fig. 3e, 3f und 3g zeigen Vorsprünge 20e, 20f und 20g, die jeweils als gesonderte Körper ausgebildet sind und jeweils in Ausnehmungen 25 der Stege 17 so eingesetzt sind, dass sie nur nach oben über die Auflagefläche 18 vorstehen. Die gesondert hergestellten Vorsprünge 20e, 20f und 20g, die alle eine gerundete Vorsprungfläche aufweisen, können beispielsweise an der Innenseite der Gehäusewände 11 und 12 festgeklebt sein.

## Patentansprüche

1. Magazin für plattenförmige Werkstücke, insbesondere Keramikträger für elektronische Bauelemente, mit zwei mit Abstand parallel zueinander verlaufenden Gehäusewänden mit Führungsnuten für Seitenränder der Werkstücke, in welchen Führungsnuten jeweils mehrere Werkstücke, durch Abstandshalter voneinander getrennt, hintereinander angeordnet sind, dadurch gekennzeichnet, dass die Abstandshalter durch Vorsprünge (20) in der Auflagefläche (18) der Führungsnuten (15) gebildet sind und dass die Breite der Führungsnuten (15) und die Höhe der Vorsprünge (20) an die Dicke der plattenförmigen Werkstücke (16) so angepasst sind, dass die Werkstücke (16) in den Führungsnuten (15) durch Anheben über die Vorsprünge (20) hinweg verschiebbar sind.

2. Magazin nach Anspruch 1, dadurch gekennzeichnet, dass die Vorsprünge (20a, 20b, 20c, 20h) durch Verformen der zwischen parallelen Führungsnuten (15) der Gehäusewände (11, 12) befindlichen Stege (17) gebildet sind.

3. Magazin nach Anspruch 1, dadurch gekennzeichnet, dass die Vorsprünge (20e, 20f, 20g) durch gesonderte Teile gebildet sind, die in Ausnehmungen (25) in den zwischen parallelen Führungsnuten (15) der Gehäusewände (11, 12) befindlichen Stege jeweils nach oben über die Auflagefläche (18) überstehend eingesetzt sind.

4. Magazin nach einem der Ansprüche 1–3, dadurch gekennzeichnet, dass die Vorsprünge (20b–20h) in Längsrichtung der Führungsnut (15) beidseitig schräge oder gerundete Aufgleitflächen (z.B. 21, 22, 23) aufweisen.

5. Magazin nach einem der Ansprüche 1–4, dadurch gekennzeichnet, dass die Gehäusewände (11, 12) mit den die Führungsnuten (15) begrenzenden Stegen (17) und den Vorsprüngen (20) einstückig ausgebildet sind.

6. Magazin nach einem der Ansprüche 1–5, dadurch gekennzeichnet, dass die Führungsnuten (15) für die plattenförmigen Werkstücke (16) über die ganze Länge der Gehäusewände (11, 12) durchlaufen und an beiden Enden einen Vorsprung (20) aufweisen und zum Wandungsrand keilförmig oder trichterförmig (19) erweitert sind.

## Revendications

1. Magasin pour pièces plates, en particulier pour des supports céramiques destinés à des composants électroniques, comprenant deux parois de boîtier qui sont éloignées et parallèles l'une à l'autre et qui sont munies de rainures de guidage destinées à des bords latéraux des pièces, plusieurs pièces séparées les unes des autres par des éléments d'écartement étant disposées les unes derrière les autres dans chaque rainure de guidage, caractérisé en ce que les éléments d'écartement sont constitués par des saillies (20) prévues dans la surface d'appui (18) des rainures de guidage (15), et en ce que la largeur des rainures de guidage (15) et la hauteur des saillies (20) sont adaptées à l'épaisseur des pièces plates (16), de manière que les pièces (16) se trouvant dans les rainures de guidage (15) puissent être déplacées en les soulevant au-dessus des saillies (20).

2. Magasin conforme à la revendication 1, caractérisé en ce que les saillies (20a, 20b, 20c, 20h) sont réalisées par déformation des nervures (17) situées entre des rainures de guidage parallèles (15) des parois de boîtier (11, 12).

3. Magasin conforme à la revendication 1, caractérisé en ce que les saillies (20e, 20f, 20g) sont formées par des pièces séparées qui sont logées dans des évidements (25) pratiqués dans les nervures situées entre des rainures de guidage parallèles (15) des parois de boîtier (11, 12) et qui dépassent de la surface d'appui (18) vers le haut.

4. Magasin conforme à l'une quelconque des revendications 1 à 3, caractérisé en ce que les saillies (20b à 20h) sont pourvues, de chaque côté, de surfaces de glissement inclinées ou arrondies (par exemple 21, 22, 23) disposées dans le sens longitudinal de la rainure de guidage (15).

5. Magasin conforme à l'une quelconque des revendications 1 à 4, caractérisé en ce que les parois de boîtier (11, 12) sont réalisées d'une seule pièce avec les nervures (17) délimitant les rainures de guidage (15) et avec les saillies (20).

6. Magasin conforme à l'une quelconque des revendications 1 à 5, caractérisé en ce que les rainures de guidage (15) destinées aux pièces plates (16) s'étendent sur toute la longueur des parois de boîtier (11, 12), en ce qu'elles comportent une saillie (20) aux deux extrémités, et en ce qu'elles sont élargies en forme de coin ou d'entonnoir (19) en direction du bord de la paroi.

## Claims

1. A magazine for plate-shaped workpieces, more especially ceramic carriers for electronic components, comprising two housing walls extending at a spacing parallel to one another and having guide grooves for lateral edges of the workpieces, in which guide grooves in each case several workpieces, separated from one another by distance pieces, are arranged one behind the other, characterised in that the distance pieces are formed by projections (20) in the bearing surface (18) of the guide grooves (15) and in that the width of the guide grooves (15) and the height of the projections (20) are so adapted to the thickness of the plate-shaped workpieces (16) that the workpieces (16) are displaceable in the guide grooves (15) by lifting over the projections (20).

2. A magazine according to claim 1, characterised in that the projections (20a, 20b, 20c, 20h) are formed by deforming the webs (17) which are present between parallel guide grooves (15) of the housing walls (11, 12).

3. A magazine according to claim 1, characterised in that the projections (20e, 20f, 20g) are formed by separate parts which are inserted in gaps (25) in the webs, present between parallel guide grooves (15) of the housing walls (11, 12), so as to project in each case upwardly over the bearing surface (18).

4. A magazine according to one of claims 1–3, characterised in that the projections (20b–20h) have, in the longitudinal direction of the guide groove (15) on both sides thereof, inclined or rounded slide-on surfaces (e.g. 21, 22, 23).

5. A magazine according to one of claims 1–4, characterised in that the housing walls (11, 12) are designed in one piece with the webs (17) bounding the guide grooves (15) and the projections (20).

6. A magazine according to one of claims 1–5, characterised in that the guide grooves (15) for the plate-shaped workpieces (16) extend the entire length of the housing walls (11, 12) and, at both ends, have a respective projection (20) and are widened towards the walling edge in a wedge-shaped or funnel-shaped manner (19).

# Fig.1

## Fig. 2

## Fig.

### 3a
### 3b
### 3c
### 3d

### 3e
### 3f
### 3g
### 3h